# EUROPÄISCHE PATENTSCHRIFT

(11) **EP 0 975 090 B1**
(45) Veröffentlichungstag und Bekanntmachung des Hinweises auf die Patenterteilung: **17.03.2004**
(21) Anmeldenummer: 99110722.8
(22) Anmeldetag: 04.06.1999
(51) Int. Cl.: H03G 11/00, H03G 11/02

(54) **Begrenzerschaltung für HF-Signale**
Limiter for radiofrequency signals
Limiteur pour signaux radiofréquences

(30) Priorität: 09.06.1998 DE 19825712
(43) Veröffentlichungstag der Anmeldung: 26.01.2000
(73) Patentinhaber: EADS Deutschland GmbH, 81663 München (DE)
(72) Erfinder: Müller, Alexander, 73560 Böbingen (DE)
(74) Vertreter: Meel, Thomas, Patentassessor

(56) Entgegenhaltungen:
- WO-A-93/16526
- US-A- 4 930 035
- MAL'TSEV A E ET AL: "INVESTIGATION OF A RING-TYPE AMPLITUDE LIMITER*" TELECOMMUNICATIONS AND RADIO ENGINEERING,US,BEGELL HOUSE, INC., NEW YORK, NY, Bd. 44, Nr. 4, 1. April 1989 (1989-04-01), Seiten 93-95, XP000215753 ISSN: 0040-2508

## Beschreibung

Die Erfindung betrifft eine Begrenzerschaltung für hochfrequente Signale mit einem HF-Eingang und einem HF-Ausgang gemäß dem Oberbegriff des Anspruchs 1.

Begrenzerschaltungen dieser Art, die im allgemeinen als Limiter bezeichnet werden, dienen dazu, nachgeordnete Bauteile oder Baugruppen wie zum Beispiel rauscharme Verstärker bzw. empfindliche Einganggstufen vor einer zu hohen HF-Spannung zu schützen. Sie finden insbesondere in Sende- und Empfangsmodulen von aktiven Antennen Anwendung und schützen hierbei den Empfänger vor zu großen Empfangssignalen und dienen im Sendebetrieb zur Erhöhung der Schleifenisolation.

Grundsätzlich besteht einerseits die Möglichkeit, eine eingestrahlte hochfrequente Spannung, die einen bestimmten Pegel überschreitet, am Eingang des Limiters durch Veränderung seines Eingangswiderstandes zu reflektieren. Hierbei besteht jedoch die Gefahr, daß sich das reflektierte Signal mit einem Sendesignal überlagert und dieses verzerrt.

Andererseits sind Limiter bekannt, in denen die eingestrahlte HF-Leistung von einem Widerstand absorbiert wird. Eine Reflexion wird dabei durch Koppler, Teiler oder eine Diodenanpassung mit Widerstand mehr oder weniger gut verhindert. Es handelt sich hierbei im allgemeinen um hybrid integrierte Limiter, die als Gemeinsamkeit eine oder mehrere Begrenzerdioden (Limiterdioden) aufweisen. Durch verschiedene hybride Aufbauten lassen sich zusätzlich zu der Eigenschaft, Signalpegel zu begrenzen, weitere Eigenschaften erzielen.

Zu diesen Limitern gehören unter anderem sogenannte "Matched Diode Limiter", die allerdings eine relativ große Einfügungsdämpfung aufgrund einer über einen Widerstand an Masse angebundenen Limiterdiode aufweisen. Zwar kann diese Dämpfung dadurch vermindert werden, daß eine Diode mit besonders geringer Kapazität verwendet wird, dies hat jedoch zur Folge, daß die absorbierende Eigenschaft des Limiters verloren geht.

Weiterhin sind Limiter mit Wilkinsonteilern bekannt, die jedoch einen relativ großen Platzbedarf haben und durch die schlechte Entkopplung der Widerstände von dem durchgehenden HF-Leitungsweg in ihrer Leistungsaufnahmefähigkeit eingeschränkt sind, oder eine relativ große Einfügungsdämpfung aufweisen. Gleiches oder Ähnliches gilt auch für zahlreiche Limiter mit anderen Kopplern (zum Beispiel Langekoppler).

Der Erfindung liegt deshalb die Aufgabe zugrunde, eine Begrenzerschaltung der eingangs genannten Art zu schaffen, die mit geringem Aufwand an Bauelementen wesentlich platzsparender als bekannte Schaltungen dieser Art zu realisieren ist.

Die erfindungsgemäße Lösung dieser Aufgabe ist in Anspruch 1 angegeben. Die Unteransprüche beinhalten vorteilhafte Weiterbildungen der Erfindung.

Die Aufgabe wird mit einer Begrenzerschaltung für hochfrequente Signale mit einem HF-Eingang und einem HF-Ausgang gelöst, die sich auszeichnet durch vier Tore und vier zu einem Ring zusammengeschaltete Leitungselemente, die jeweils zwei Tore mit einer Phasenverschiebung von im wesentlichen einem Viertel der Signal-Wellenlänge miteinander verbinden, wobei ein erstes Tor den HF-Eingang bildet, zwischen ein in einer Umfangsrichtung folgendes zweites Tor und Masse ein Widerstand geschaltet ist, an ein folgendes drittes Tor der HF-Ausgang und eine erste Begrenzerdiode in Durchlaßrichtung nach Masse, und an ein viertes Tor eine zweite Begrenzerdiode in Durchlaßrichtung nach Masse geschaltet ist.

Besondere Vorteile dieser Lösung bestehen darin, daß die Einkopplungsdämpfung der Schaltung sehr gering ist und daß sie im Großsignalfall in Richtung ihres Eingangs nicht reflektiert. Ferner ist der zur Realisierung erforderliche Flächenbedarf wesentlich geringer ist als bei allen bekannten Limitern.

Bei einer bevorzugten Ausführungsform der Erfindung sind die Leitungselemente jeweils Leitungsstücke, deren Länge etwa einem Viertel der Wellenlänge der zu begrenzenden HF-Spannung entspricht.

Alternativ dazu können die Leitungselemente auch jeweils durch eine Zusammenschaltung von induktiven und kapazitiven Elementen gebildet sein.

Die Begrenzerschaltung wird vorzugsweise in Mikrostreifenleitungstechnik realisiert, wobei jedoch auch Hohlleiterschaltungen und andere Schaltungsarten, insbesondere solche auf Halbleiterbasis denkbar sind.

Ferner kann auch eine weitere, in Reihe geschaltete Begrenzerstufe mit einer dritten Begrenzerdiode vorgesehen sein.

Weitere Einzelheiten, Merkmale und Vorteile der Erfindung ergeben sich aus der folgenden Beschreibung von bevorzugten Ausführungsformen anhand der Zeichnung. Es zeigen:
- Fig. 1: ein Prinzipschaltbild einer erfindungsgemäßen Begrenzerschaltung;
- Fig. 2: eine erste Ausführungsform der Begrenzerschaltung in Mikrostreifenleitungstechnik;
und
- Fig. 3: eine zweite Ausführungsform der Begrenzerschal tung in Mikrostreifenleitungstechnik.

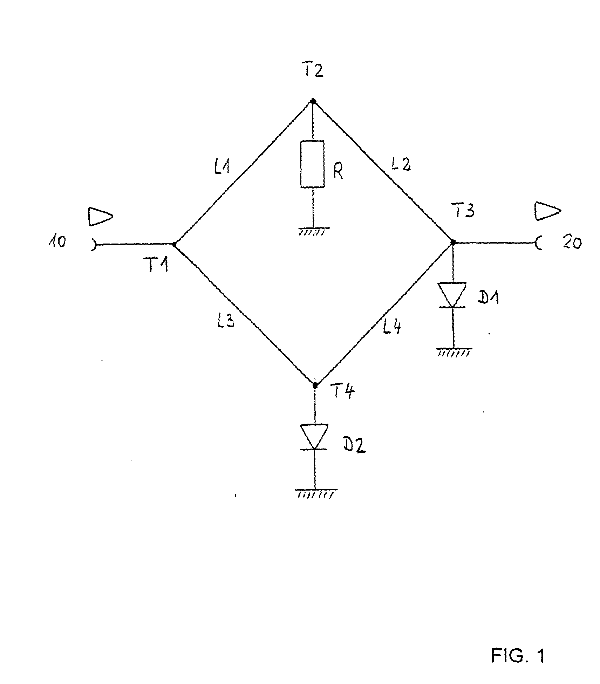

Eine erfindungsgemäße Begrenzerschaltung weist gemäß Figur 1 einen HF-Eingang 10 und einen HF-Ausgang 20 auf. Zwischen den HF-Eingang 10 und den HF-Ausgang 20 ist ein aus vier Leitungselementen L1, L2, L3, L4 gebildeter Ring geschaltet. Der Ring verbindet vier Tore T1, T2, T3, T4 miteinander, wobei jedes zwischen zwei Toren liegende Leitungselement jeweils eine Phasenverschiebung des HF-Signals von etwa einem Viertel der Signal-Wellenlänge bewirkt.

Der HF-Eingang 10 der Schaltung ist mit dem ersten Tor T1 verbunden, während der HF-Ausgang 20 an das dritte, diesem gegenüberliegende Tor T3 geschaltet ist. Zwischen dem zweiten Tor T2 und Masse liegt ein Widerstand R. Weiterhin ist zwischen das dritte Tor T3 und Masse eine erste Begrenzerdiode D1 und zwischen das vierte Tor T4 und Masse eine zweite Begrenzerdiode D2 geschaltet.

Im Kleinsignalfall befinden sich die Begrenzerdioden D1, D2 in sperrendem Zustand. Das in den HF-Eingang 10 eintretende Signal breitet sich ungehindert einerseits entlang des ersten und zweiten Leitungselementes L1, L2 und andererseits entlang des dritten und vierten Leitungselementes L3, L4 aus und verläßt am HF-Ausgang 20 die Begrenzerschaltung. Der Widerstand R ist dabei von dem HF-Eingang 10 entkoppelt, da die an dem zweiten Tor T2 anliegenden Signalspannungen gegenphasig sind und sich auslöschen, so daß der mit diesem Tor verbundene Widerstand R keinen Einfluß auf das HF-Eingangssignal ausüben kann.

Im Großsignalfall ist der in den HF-Eingang 10 eintretende Signalpegel so groß geworden, daß die Begrenzerdioden D1, D2 durchschalten und sich nun im leitenden Zustand befinden. Die Dioden schließen somit das dritte und vierte Tor T3, T4 gegen Masse. Dies hat eine Fehlanpassung der mit diesen Toren verbundenen Leitungselemente zur Folge, so daß die Signale an diesen Toren reflektiert werden.

Im einzelnen wird das sich entlang des ersten und zweiten Leitungselementes L1, L2 ausbreitende Signal an dem dritten Tor T3 reflektiert, während das entlang des dritten Leitungselementes L3 laufende Signal an dem vierten Tor T4 reflektiert wird. Aufgrund der durch die unterschiedlichen Wege bewirkten Phasenverschiebungen sind die an dem ersten Tor T1 eintreffenden Signale gegenphasig und löschen sich aus, während die an dem zweiten Tor T2 anliegenden Signale gleiche Phase aufweisen und sich addieren. Das Signal wird somit vollständig von dem an das zweite Tor T2 angeschalteten Widerstand R absorbiert (d.h. in Wärme umgesetzt), ohne daß eine Rückreflexion in den HF-Eingang 10 auftritt. Zwar ist in diesem Betriebsfall der Ausgang fehlangepaßt, dies wirkt sich jedoch im praktischen Betrieb deshalb nicht ungünstig aus, weil dabei ein an den HF-Ausgang 20 angeschlossener Verstärker im allgemeinen weit in der Sättigung betrieben wird.

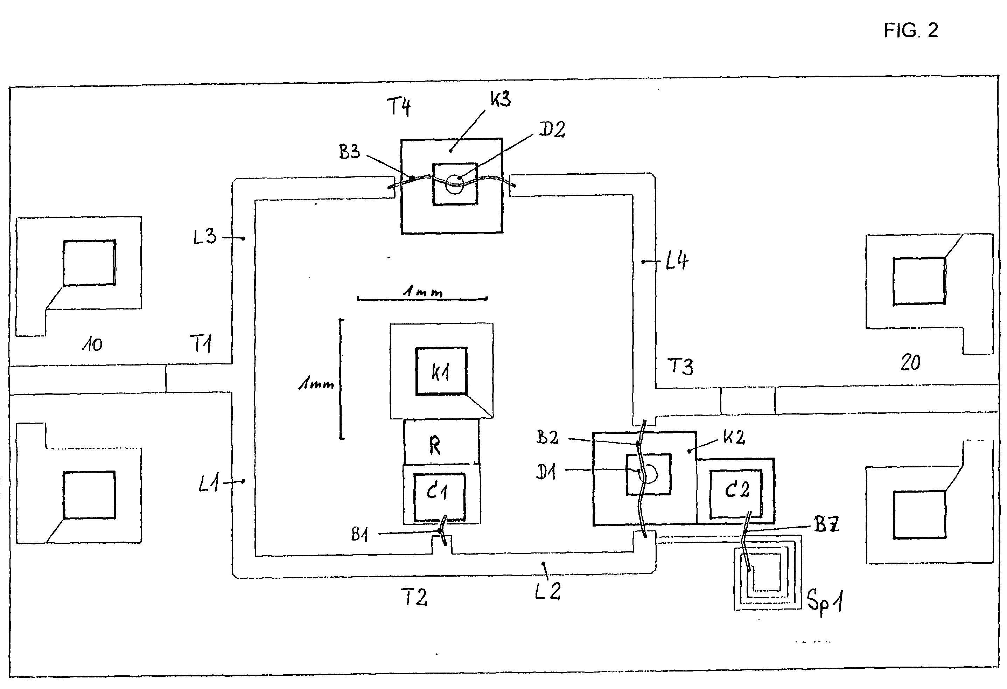

Figur 2 zeigt eine erste Ausführungsform einer erfindungsgemäßen Begrenzerschaltung, die mit dem dargestellten Maßstab insbesondere für einen Frequenzbereich von etwa 10 GHz (X-Band) geeignet ist. Die Schaltung kann durch entsprechende Umskalierung auch für andere Frequenzbereiche entworfen werden.

Die Schaltung wurde in Mikrostreifenleitungstechnik auf einem Al_{2O}3-Substrat mit einer Dicke von etwa 0,254 mm realisiert.

Die Schaltung weist einen HF-Eingang 10 und einen HF-Ausgang 20 auf. Der HF-Eingang ist zu einem ersten Tor T1 geführt, von dem aus sich ein erstes und ein drittes Leitungselement L1, L3 erstreckt. Am Ende des ersten Leitungselementes L1 befindet sich ein zweites Tor T2, während das dritte Leitungselement L3 mit einem vierten Tor T4 abgeschlossen ist. An das zweite Tor T2 schließt sich ein zweites Leitungselement L2 an, das in einem dritten Tor T3 endet. In diesem Tor endet schließlich auch ein viertes Leitungselement L4, das von dem vierten Tor T4 ausgeht, so daß insgesamt ein sogenannter Ringkoppler entsteht. Der HF-Ausgang 20 ist mit dem dritten Tor T3 verbunden.

Die Leitungselemente L1 bis L4 sind in Form von Mikrostreifenleitungen ausgebildet, die jeweils eine Länge von etwa einem Viertel der HF-Signalwellenlänge aufweisen. Die tatsächlich etwas voneinander abweichenden Längen zum Beispiel des zweiten Leitungselementes L2 von denen der anderen Leitungselemente sind durch die nicht ideale Anpassung der nachfolgend beschriebenen Bauelemente bedingt.

An das zweite Tor T2 ist mit einem ersten Bonddraht B1 ein erster Kondensator C1 sowie in Reihe zu diesem der Widerstand R geschaltet, dessen anderer Anschluß über eine erste Durchkontaktierung (Durchgang) K1 an Masse geführt ist. Der Widerstand R ist ein Schichtwiderstand und hat etwa 100 Ohm.

In dem Bereich des dritten Tores T3 befindet sich eine zweiter, nicht metallisierter Durchgang (Loch) K2. Die darin liegende erste Begrenzerdiode D1 ist mit ihrer Anode über einen zweiten Bonddraht B2 mit dem dritten Tor T3 verbunden und mit ihrer Kathode leitend auf eine Massepotential bildende metallische Trägerplatte des Substrates geklebt. Außerdem befindet sich in dem zweiten Durchgang K2 ein zweiter Kondensator C2, der einerseits über einen zusätzlichen Bonddraht BZ und eine planare Spule Sp1 mit dem dritten Tor T3 verbunden und andererseits leitend auf die das Massepotential bildende metallische Trägerplatte des Substrates geklebt ist. Der zweite Bonddraht B2 stellt außerdem eine elektrische Verbindung zwischen dem zweiten und dem vierten Leitungselement L2, L4 her.

An dem vierten Tor T4 befindet sich in einem dritten, nicht metallisierten Durchgang K3 die zweite Begrenzerdiode D2, deren Anode über einen dritten Bonddraht B3 mit dem vierten Tor T4 verbunden, und deren Kathode leitend auf die das Massepotential bildende metallische Trägerplatte des Substrates geklebt ist. Der dritte Bonddraht B3 verbindet außerdem das dritte Leitungselement L3 mit dem vierten Leitungselement L4.

Als Begrenzerdioden D1 und D2 wurden jeweils die Typen CLA 3134 der Firma Alpha und als Kondensatoren C1 und C2 die Typen D15NS3R9 D5PX der Firma DLI mit jeweils 3,9 pF verwendet.

Die Funktion dieser Schaltung ist die gleiche, wie sie anhand des Prinzipschaltbildes gemäß Figur 1 beschrieben wurde. Die im Vergleich zu Figur 1 zusätzlichen Elemente C1, C2 und Sp1 haben folgende Funktion: Der zweite Kondensator C2 sowie die über den Bonddraht BZ mit diesem verbundene Spule Sp1 dienen zur Zuführung einer Vorspannung (Biasversorgung). Bei der Verwendung der Begrenzerschaltung in einem Sende- und Empfangsmodul sollen die Begrenzerdioden D1, D2 im Sendefall mit einem Strom von jeweils etwa 10 mA gespeist werden. Dabei verhindert der erste Kondensator C1, daß Gleichströme über den Widerstand R fließen. Im Empfangsfall soll hingegen die Vorspannung mit dem zweiten Kondensator C2 nach Masse kurzgeschlossen werden, um den pegelbegrenzenden Effekt der Begrenzerdioden D1, D2 zu gewährleisten.

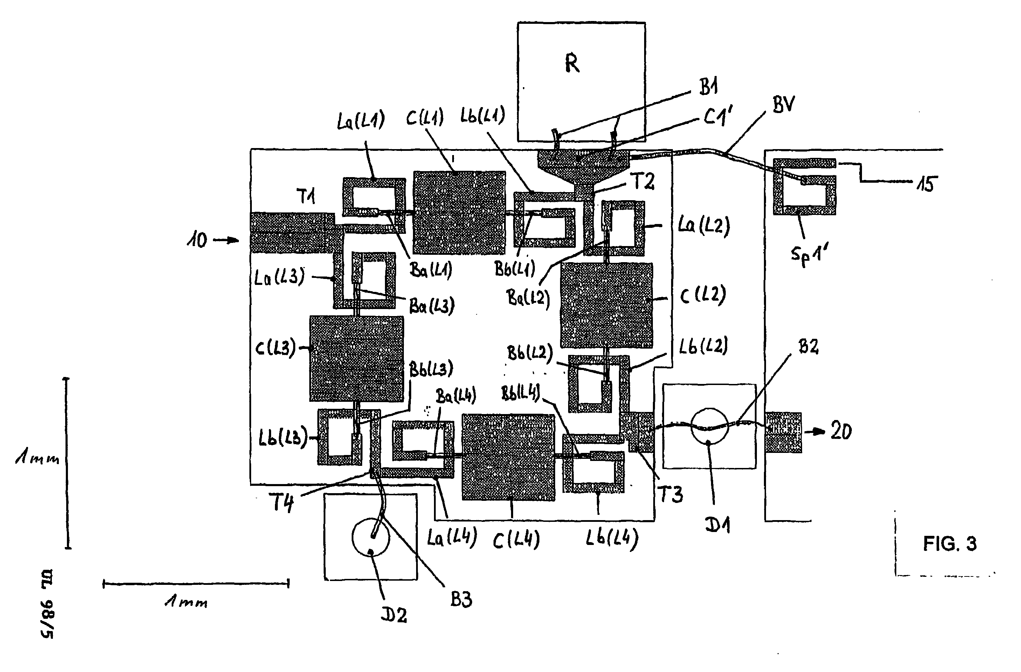

Figur 3 zeigt eine zweite Ausführungsform der Erfindung, die als planare Schaltung ebenfalls in Mikrostreifenleitungstechnik realisiert wurde. Beispielhaft wurde die Schaltung mit dem in dieser Figur dargestellten Maßstab entworfen, der für einen Frequenzbereich von etwa 10 GHz (X-Band) geeignet ist. Die Schaltung kann bei entsprechender Umskalierung auch für andere Frequenzbereiche entworfen werden.

Im Unterschied zur ersten Ausführungsform sind die Leitungselemente L1 bis L4 zur Erzeugung der Phasenverschiebungen von einem Viertel der HF-Signal-Wellenlänge nicht mit entsprechend bemessenen Mikrostreifenleitungen, sondern mit konzentrierten induktiven und kapazitiven Elementen (sogenannte Lumped Elements) realisiert worden.

Im einzelnen ist wiederum der HF-Eingang 10 an das erstes Tor T1 geführt, von dem aus sich das erste und das dritte Leitungselement L1, L3 erstreckt. Am Ende des ersten Leitungselementes L1 befindet sich das zweite Tor T2, während das dritte Leitungselement L3 mit dem vierten Tor T4 abgeschlossen ist. An das zweite Tor T2 schließt sich das zweite Leitungselement L2 an, das in dem dritten Tor T3 endet. In diesem Tor endet schließlich auch das vierte Leitungselement L4, das von dem vierten Tor T4 ausgeht, so daß insgesamt ein sogenannter Ringkoppler entsteht. Der HF-Ausgang 20 ist mit dem dritten Tor T3 verbunden.

Die vier Leitungselemente L1 bis L4 stellen jeweils eine Reihenschaltung aus einer Induktivität La(L1) bis La(L4), einer Kapazität C(L1) bis C(L4), sowie einer weiteren Induktivität Lb(L1) bis Lb(L4) dar. Die Induktivitäten sind jeweils durch eine mit Mikrostreifenleitungen gebildete Schleife realisiert, während die Kapazitäten durch ein flächiges Mikrostreifenleitungselement erzielt werden. Diese sogenannten konzentrierten Elemente sind über Bonddrähte Ba(L1) bis Ba(L4) und Bb(L1) bis Bb(L4) miteinander verbunden.

Ferner ist auch bei dieser Ausführungsform der Widerstand R von etwa 100 Ohm über erste Bonddrähte B1 einerseits an das zweite Tor T2 und andererseits an Masse geschaltet, während die Anode der ersten Begrenzerdiode D1 über den zweiten Bonddraht B2 mit dem dritten Tor T3 und die Anode der zweiten Begrenzerdiode D2 über den dritten Bonddraht B3 mit dem vierten Tor T4 verbunden ist. Die Kathoden der Begrenzerdioden D1 und D2 liegen an Masse.

Auch bei dieser zweiten Ausführungsform sind im Vergleich zu Figur 1 zusätzliche Elemente C1', C2' (nicht dargestellt) und Sp1' vorhanden, die bereits im Zusammenhang mit der ersten Ausführungsform beschrieben wurden und hier die gleiche Funktion haben. Der erste Kondensator C1' verhindert, daß im Sendefall Gleichströme über den Widerstand R fließen, während im Empfangsfall die zur Zuführung der Vorspannung dienende Leitung 15, die über die Spule Sp1 und den Bonddraht BV mit dem zweiten Topr T2 verbunden ist, über den zweiten Kondensator C2' (nicht dargestellt) gegen Masse kurzgeschlossen wird.

Diese Ausführungsform ist insbesondere dann vorzuziehen, wenn eine sehr kleine Bauform wichtig ist. Für sehr kurze Wellenlängen ist hingegen die erste Ausführungsform fertigungstechnisch einfacher und kostengünstiger zu realisieren.

Weitere Realisierungen des in Figur 1 gezeigten Prinzipschaltbildes, zum Beispiel in Hohlleitertechnik und/ oder auf Halbleiterbasis, sind möglich und werden in Abhängigkeit von dem gewünschten Frequenzbereich gewählt.

## Patentansprüche

1. Begrenzerschaltung für hochfrequente Signale mit einem HF-Eingang und einem HF-Ausgang, **gekennzeichnet durch** vier Tore (T1, T2, T3, T4) und vier zu einem Ring zusammengeschaltete Leitungselemente (L1, L2, L3, L4), die jeweils zwei Tore mit einer Phasenverschiebung von im wesentlichen einem Viertel der Signal-Wellenlänge miteinander verbinden, wobei ein erstes Tor (T1) den HF-Eingang (10) bildet, zwischen ein in einer Umfangsrichtung folgendes zweites Tor (T2) und Masse ein Widerstand (R) geschaltet ist, an ein folgendes drittes Tor (T3) der HF-Ausgang (20) und eine erste Begrenzerdiode (D1) in Durchlaßrichtung nach Masse, und an ein viertes Tor (T4) eine zweite Begrenzerdiode (D2) in Durchlaßrichtung nach Masse geschaltet ist.

2. Begrenzerschaltung nach Anspruch 1, **dadurch gekennzeichnet, daß** die Leitungselemente jeweils Leitungsstücke sind, deren Länge etwa einem Viertel der Wellenlänge der zu begrenzenden HF-Spannung entspricht.

3. Begrenzerschaltung nach Anspruch 1, **dadurch gekennzeichnet, daß** die Leitungselemente jeweils durch eine Zusammenschaltung von induktiven und kapazitiven Elementen gebildet sind.

4. Begrenzerschaltung nach einem der vorhergehenden Ansprüche, **dadurch gekennzeichnet, daß** sie in Mikrostreifenleitungstechnik realisiert ist.

5. Begrenzerschaltung nach einem der vorhergehenden Ansprüche, **dadurch gekennzeichnet, daß** eine weitere, in Reihe geschaltete Begrenzerstufe mit einer dritten Begrenzerdiode vorgesehen ist.

6. Begrenzerschaltung nach einem der vorhergehenden Ansprüche, **dadurch gekennzeichnet, daß** sie für einen Betrieb im Bereich von 10 GHz ausgelegt ist.

## Claims

1. Limiter circuit for radio-frequency signals having an RF input and an RF output, **characterized by** four ports (T1, T2, T3, T4) and four line elements (L1, L2, L3, L4), which are interconnected to form a ring and each connect two ports to one another with a phase shift of essentially one quarter of the signal wavelength, with a first port (T1) forming the RF input (10), a resistor (R) being connected between a second port (T2), which follows the first port (T1) in the circumferential direction, and earth, the RF output (20) and a first limiter diode (D1) (with the forward-bias direction to earth) being connected to a following third port (T3), and the second limiter diode (D2), with the forward-bias direction to earth, being connected to a fourth port (T4).

2. Limiter circuit according to Claim 1, **characterized in that** the line elements are each line pieces whose length corresponding approximately to one quarter of the wavelength of the RF voltage to be limited.

3. Limiter circuit according to Claim 1, **characterized in that** the line elements are each formed by interconnection of inductive and capacitive elements.

4. Limiter circuit according to one of the preceding claims, **characterized in that** the limiter circuit is designed using microstripline technology.

5. Limiter circuit according to one of the preceding claims, **characterized in that** a further, series-connected limiter state is provided with a third limiter diode.

6. Limiter circuit according to one of the preceding claims, **characterized in that** the limiter circuit is designed for operation in the region of 10 GHz.

## Revendications

1. Limiteur pour signaux radiofréquence avec une entrée HF et une sortie HF, **caractérisé par** quatre portes (T1, T2, T3, T4) et quatre éléments conducteurs (L1, L2, L3, L4) interconnectés en forme d'anneau qui relient chacun deux portes entre elles avec un décalage de phase sensiblement égal à un quart de la longueur d'onde du signal, dans lequel une première porte (T1) constitue l'entrée HF (10), une résistance (R) est connectée entre une deuxième porte (T2) située en aval dans le sens de la périphérie et la masse, une première diode limitatrice (D1) sur une troisième porte (T3) située en aval faisant office de sortie HF (20), dans le sens de conduction vers la masse, et une deuxième diode limitatrice (D2) sur une quatrième porte (T4), dans le sens de conduction vers la masse.

2. Limiteur selon la revendication 1, **caractérisé en ce que** les éléments conducteurs sont chacun des conducteurs dont la longueur correspond environ au quart de la longueur d'onde de la tension HF à limiter.

3. Limiteur selon la revendication 1, **caractérisé en ce que** les éléments conducteurs sont formés par un assemblage d'éléments inductifs et capacitifs.

4. Limiteur selon l'une quelconque des revendications précédentes, **caractérisé en ce qu'**il est réalisé par la technique des microbandes.

5. Limiteur selon l'une quelconque des revendications précédentes, **caractérisé en ce qu'**un autre étage de limitation monté en série et présentant une troisième diode limitatrice est prévu.

6. Limiteur selon l'une quelconque des revendications précédentes, **caractérisé en ce qu'**il est conçu pour fonctionner sur la plage de 10 GHz.
